# EUROPEAN PATENT SPECIFICATION

(11) **EP 4 300 549 B1**
(45) Date of publication and mention of the grant of the patent: **25.02.2026**
(21) Application number: 21933834.0
(22) Date of filing: 31.03.2021
(51) Int. Cl.: H10D 30/01, H10D 30/66, H10D 62/57, H01L 21/263, H01L 21/326, G01R 31/26

(54) **FIELD EFFECT TRANSISTOR AND MANUFACTURING METHOD THEREFOR, AND SWITCHING CIRCUIT AND CIRCUIT BOARD**
FELDEFFEKTTRANSISTOR UND HERSTELLUNGSVERFAHREN DAFÜR SOWIE SCHALTKREIS UND LEITERPLATTE
TRANSISTOR À EFFET DE CHAMP ET SON PROCÉDÉ DE FABRICATION, AINSI QUE CIRCUIT DE COMMUTATION ET CARTE DE CIRCUIT IMPRIMÉ

(43) Date of publication of application: 03.01.2024
(73) Proprietor: Huawei Technologies Co., Ltd., Shenzhen, Guangdong 518129 (CN)
(72) Inventor: ZHANG, Yuhua, Shenzhen, Guangdong 518129 (CN); KE, Xingfei, Shenzhen, Guangdong 518129 (CN); ZHOU, Mingtao, Shenzhen, Guangdong 518129 (CN); YANG, Mengqi, Shenzhen, Guangdong 518129 (CN); XU, Gaochao, Shenzhen, Guangdong 518129 (CN)
(74) Representative: Maiwald GmbH
(86) International application number: PCT/CN2021/084674
(87) International publication number: WO 2022/205169

(56) References cited:
- CN-A- 106 784 001
- CN-A- 108 565 212
- GB-A- 2 154 366
- JP-A- H09 298 165
- US-A1- 2006 211 189
- US-A1- 2015 008 478
- US-B1- 6 703 665
- US-B2- 9 117 709

## Description

### TECHNICAL FIELD

This application relates to the field of semiconductor technologies, and in particular, to a field-effect transistor, a production method thereof, a switching circuit, and a circuit board.

### BACKGROUND

Metal-oxide-semiconductor field-effect transistors (MOSFET) are referred to as field-effect transistors, MOS transistors, MOS devices, or the like for short. Being unipolar voltage-driven devices and with features such as a low conduction loss and a high switching frequency, metal-oxide-semiconductor field-effect transistors are widely used in application fields such as switching circuits and communication devices.

In some application scenarios, a MOS device is frequently conducted and cut off. After the MOS device is conducted, large quantities of electrons and holes are stored inside the device. When the MOS device is cut off, excess electrons and holes inside the device need to be recombined or removed as soon as possible. To ensure performance of the MOS device, so as to meet a requirement of an application end, reverse recovery performance of a parasitic diode in the MOS device needs to be improved. A method for reducing a minority carrier lifetime of the MOS device may be used, to speed up recombination of excess electron-hole pairs that result from conduction of the parasitic diode. In this way, the reverse recovery performance of the parasitic diode in the MOS device is improved.

The minority carrier lifetime of the MOS device may be understood as a period of time from generation to disappearance of minority carriers in a semiconducting material. Defect energy levels may be introduced to a forbidden band in a semiconductor using a lifetime control technique. These defect energy levels may form a recombination center, which facilitates recombination of electrons in a conduction band with holes in a valence band, speeding up recombination of the minority carriers, reducing the minority carrier lifetime and reverse recovery charges, and further improving the reverse recovery performance of the parasitic diode in the MOS device.

In a related technology, a commonly used lifetime control technique is irradiation. In an irradiation process, a MOS device is bombarded by high-energy particles, forming unstable trapped charges at an insulating oxide layer and at an interface between the insulating oxide layer and a semiconductor substrate in the MOS device. These trapped charges are difficult to remove. As a result, performance of the MOS device deteriorates. For example, a leakage current at a drain of the MOS device increases, uniformity of leakage currents decreases, and convergence of a drain-source withstanding voltage (which may be understood as a breakdown voltage) of the MOS device deteriorates.

US 2015/0008478 A1 describes a manufacturing method of a semiconductor device comprising the irradiation with an electron ray of the field-effect transistors on a substrate side on which the gates and sources are formed. The method further comprises an annealing step for repairing the crystal defects generated in the gate insulation film and the gate electrode by the irradiating step.

GB 2154366 A describes a construction of a field effect transistor.

### SUMMARY

Embodiments of this application provide a field-effect transistor, a production method thereof, a switching circuit, and a circuit board, to reduce a leakage current at a drain, increase uniformity of leakage currents, and improve convergence of a drain-source withstanding voltage.

The present invention is defined by the subject-matter of the independent claim 1. Additional features of the invention are presented in the dependent claims.

According to a first aspect, an embodiment of this application provides a field-effect transistor production method. The production method includes : providing field-effect transistors and irradiating the field-effect transistors; and applying a specified current to drains of the field-effect transistors for specified duration, and applying a same specified voltage to gates and sources of the field-effect transistors. The specified voltage is a grounding voltage or reverse voltage. The grounding voltage is a voltage of 0V relative to a ground voltage. The reverse voltage is a voltage opposite to a forward conduction voltage in positive and negative senses of values. For example, if the forward conduction voltage is a positive voltage, the reverse conduction voltage is a negative voltage.

In this embodiment of this application, the field-effect transistors are irradiated, reducing minority carrier lifetimes of the field-effect transistors, and further improving reverse recovery performance of parasitic diodes in the field-effect transistors. However, during the irradiation, the field-effect transistors are bombarded by high-energy particles, forming unstable trapped charges at an insulating oxide layer and at an interface between the insulating oxide layer and a semiconductor substrate. These trapped charges are difficult to remove. As a result, for the plurality of field-effect transistors on the same semiconductor substrate (for example, a wafer), some field-effect transistors have many unstable trapped charges, some field-effect transistors have few unstable trapped charges, and some field-effect transistors even do not have trapped charges, resulting in low uniformity in performance of the plurality of field-effect transistors on the same semiconductor substrate. In this embodiment of this application, the specified current is applied to the drains of the field-effect transistors for the specified duration, and the same specified voltage is applied to the gates and sources, enabling the field-effect transistors to be in a reverse biased state in a case of cut-off. The reverse biased state is a state opposite to a forward conducting state. For example, a field-effect transistor is an N-type transistor. When a positive voltage is applied to a gate, the field-effect transistor is forward conducted. When a negative voltage is applied to the gate, the field-effect transistor is in a reverse biased state. In addition, a specific quantity of electron-hole pairs may be generated at the insulating oxide layer and at the interface between the insulating oxide layer and the semiconductor substrate. These electron-hole pairs may recombine with the trapped charges, removing the unstable trapped charges generated during the irradiation. In this way, the trapped charges in the plurality of field-effect transistors on the same semiconductor substrate are all in a stable state, and differences between performance of the different field-effect transistors on the same semiconductor substrate are slight, increasing uniformity in performance of the plurality of field-effect transistors on the same semiconductor substrate. In other words, leakage currents at the drains can be reduced, uniformity of leakage currents can be increased, convergence of a drain-source withstanding voltage can be improved, and further, the field-effect transistors can be used in a wider range of fields. In addition, the same specified voltage is applied to the gates and sources of the field-effect transistors, keeping the gates and sources at a same potential, to prevent the field-effect transistors from being broken down in the reverse biased state.

In a possible implementation of this application, the specified current is in a range of 0.1 µA to 100 mA. In this embodiment of this application, the specified current in the range of 0.1 µA to 100 mA is applied to the drains of the field-effect transistors, preventing the field-effect transistors from being burnt out on a basis of ensuring that enough electron-hole pairs are generated.

In a possible implementation of this application, the specified duration is in a range of 1 µs to 100s. In this embodiment of this application, duration for which the specified current is applied to the drains is controlled to be in the range of 1 µs to 100s, preventing the field-effect transistors from being damaged on a basis of ensuring that enough electron-hole pairs are generated. During specific implementation, the specified duration for which the current is applied to the drains may be determined based on a magnitude of the specified current applied to the drains. For example, if the specified current applied to the drains is large, the duration for which the specified current is applied to the drains may be shortened, and may be set based on an actual requirement. The magnitude of the specified current and the specified duration are not limited herein.

In a possible implementation of this application, when the field-effect transistors are P-type transistors, the reverse voltage is a positive voltage; and when the field-effect transistors are N-type transistors, the reverse voltage is a negative voltage. In this way, the field-effect transistors can be kept in the reverse biased state.

In this embodiment of this application, the providing field-effect transistors and irradiating the field-effect transistors includes: forming the gates and sources of the plurality of field-effect transistors on a surface of one side of the semiconductor substrate; irradiating the semiconductor substrate on which the gates and sources are formed; and forming the drains of the plurality of field-effect transistors on a surface of the other side of the semiconductor substrate, to obtain the plurality of field-effect transistors.

In this embodiment of this application, after front sides of the field-effect transistors are processed and before back sides of the field-effect transistors are processed, the semiconductor substrate on which the gates and sources are formed is irradiated, making an irradiation process fully compatible with a production process of the field-effect transistors. In addition, after the front sides of the field-effect transistors are processed, the semiconductor substrate on which the gates and sources are formed may be directly placed in an irradiation device, with no need to turn over the semiconductor substrate repeatedly. In this case, a processing procedure is simpler, facilitating mass production.

Certainly, alternatively, the field-effect transistors is irradiated after the back sides of the field-effect transistors are processed. To be specific, the providing field-effect transistors and irradiating the field-effect transistors alternatively includes : forming the gates and sources of the plurality of field-effect transistors on a surface of one side of the semiconductor substrate; forming the drains of the plurality of field-effect transistors on a surface of the other side of the semiconductor substrate, to obtain the field-effect transistors; and irradiating the obtained field-effect transistors.

In this embodiment of this application, the irradiation includes electron irradiation, proton irradiation, or neutron irradiation. During specific implementation, a type of irradiation may be determined based on an actual requirement.

In a possible implementation of this application, after the irradiating the field-effect transistors, the production method may further include: annealing the field-effect transistors. During the irradiation, the field-effect transistors are bombarded by high-energy particles, forming trapped charges at the insulating oxide layer and at the interface between the insulating oxide layer and the semiconductor substrate. With the annealing operation performed, some trapped charges can be removed, improving leakage current performance and voltage withstanding performance of the field-effect transistors. However, generally, not all trapped charges can be removed by performing the annealing operation. In this embodiment of this application, after the irradiation, the specified current is applied to the drains of the field-effect transistors, and the same specified voltage is applied to the gates and sources. In this way, the field-effect transistors are in the reverse biased state in a case of cut-off, and a specific quantity of electron-hole pairs are generated at the insulating oxide layer and at the interface between the insulating oxide layer and the semiconductor substrate. These electron-hole pairs may recombine with the trapped charges. Therefore, the trapped charges generated during the irradiation are further removed, and the leakage current performance and the voltage withstanding performance of the field-effect transistors are further improved.

In a possible implementation of this application, the production method may further include: in a first test phase, detecting static parameters of the plurality of irradiated field-effect transistors that share the same semiconductor substrate, and comparing the static parameters with preset standard parameters, to obtain a plurality of tested field-effect transistors; separating the plurality of field-effect transistors that are obtained after the first test phase ends, to obtain a plurality of field-effect transistors; and in a second test phase that follows the first test phase, detecting static parameters of the plurality of obtained field-effect transistors, and comparing the static parameters with preset standard parameters, to obtain a plurality of tested field-effect transistors. In this embodiment of this application, in the first test phase and/or the second test phase, the specified current may be applied to the drains of the field-effect transistors for the specified duration. In this way, the step of applying a specified current to drains of the field-effect transistors may be made compatible with a test process, with no need to add a new process, facilitating mass production and saving production costs.

According to a second aspect, an embodiment of this application not according to the invention and present for illustration purposes further provides a field-effect transistor, which may be used in an integrated circuit. The field-effect transistor is produced using any one of the foregoing production methods. In the foregoing production method, a current in a specific range of values is applied to drains of field-effect transistors for specified duration, and a same specified voltage is applied to gates and sources. In this way, the field-effect transistors can be in a reverse biased state in a case of cut-off, and a specific quantity of electron-hole pairs can be generated at an insulating oxide layer and at an interface between the insulating oxide layer and a semiconductor substrate. These electron-hole pairs may recombine with trapped charges, removing the trapped charges generated during irradiation. Therefore, for the field-effect transistor obtained using the foregoing production method, a leakage current at a drain is low, uniformity of leakage currents is high, and convergence of a drain-source withstanding voltage is good.

According to a third aspect, an embodiment of this application not according to the invention and present for illustration purposes further provides a switching circuit. The switching circuit may be a switching circuit in an AC-DC converter circuit, a high-voltage converter circuit, or a half-bridge rectifier circuit. The switching circuit includes a main board and any one of the foregoing field-effect transistors provided in embodiments of this application. The field-effect transistor is disposed on the main board. In this embodiment of this application, when any one of the foregoing production methods is used, trapped charges generated during irradiation can be removed, and an obtained field-effect transistor performs well. For example, a drain-source withstanding voltage of the field-effect transistor is high. Further, a switching circuit including the field-effect transistor also performs well. The switching circuit resolves a problem in a similar way to the foregoing field-effect transistor. Therefore, for implementation of the switching circuit, refer to implementation of the foregoing field-effect transistor. Repeated details are not described.

According to a fourth aspect, an embodiment of this application not according to the invention and present for illustration purposes further provides a circuit board. The circuit board includes any one of the foregoing field-effect transistors, or includes the foregoing switching circuit. The circuit board may be a printed circuit board (PCB) or another type of circuit board. This is not limited herein.

### BRIEF DESCRIPTION OF DRAWINGS

FIG. 1 is a schematic diagram of a structure of a field-effect transistor;
FIG. 2 is a schematic diagram of another structure of a field-effect transistor; and
FIG. 3 is a flowchart of a field-effect transistor production method according to an embodiment of this application.

### Reference numerals:

101: semiconductor substrate; 102: insulating oxide layer; G: gate; S: source; D: drain; I: specified current; U: specified voltage.

### DESCRIPTION OF EMBODIMENTS

To make objectives, technical solutions, and advantages of this application clearer, the following further describes this application in detail with reference to the accompanying drawings.

Embodiments of this application not according to the invention and present for illustration purposes provide a field-effect transistor, a switching circuit, and a circuit board. The embodiment of this application according the invention provides a production method of a metal-oxide-semiconductor field-effect-transistor. The production method may be used to produce various metal-oxide-semiconductor field-effect transistors, for example, trench field-effect transistors (Trench MOS), shield gate trench field-effect transistors (SGT), or insulated gate bipolar transistors (IGBT). Certainly, the production method in embodiments of this application may also be used to produce other field-effect transistors. Examples are not listed herein one by one.

It should be noted that, in this specification, similar reference numerals and letters in the following accompanying drawings represent similar items. Therefore, once an item is defined in an accompanying drawing, the item does not need to be further defined or interpreted in following accompanying drawings.

To describe the production method in embodiments of this application more clearly, the following describes structures of field-effect transistors with reference to the accompanying drawings.

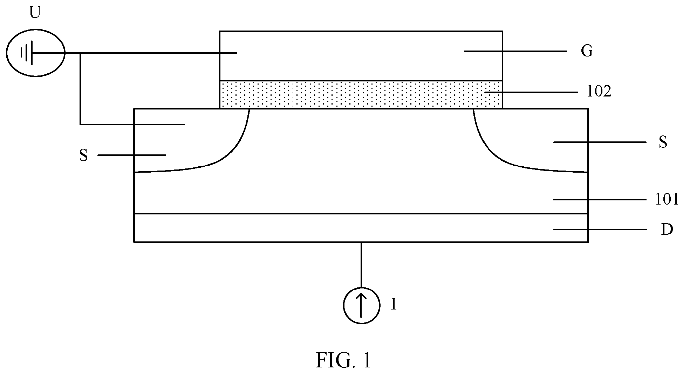

FIG. 1 is a schematic diagram of a structure of a field-effect transistor. As shown in FIG. 1, the field-effect transistor may include a semiconductor substrate 101, a source S, a drain D, a gate G, and an insulating oxide layer 102. The source S and the drain D are located on two sides of the semiconductor substrate 101, respectively. Optionally, a material of the semiconductor substrate 101 may include silicon, and a material of the insulating oxide layer 102 may include silicon oxide.

In the field-effect transistor shown in FIG. 1, the gate G and the source S are located on one side of the semiconductor substrate 101, and the drain D is located on the other side of the semiconductor substrate 101. In this way, when the field-effect transistor is conducted, a current flows from the drain D to the source S. To be specific, the current flows vertically in the semiconductor substrate 101, fully utilizing an area of the semiconductor substrate 101.

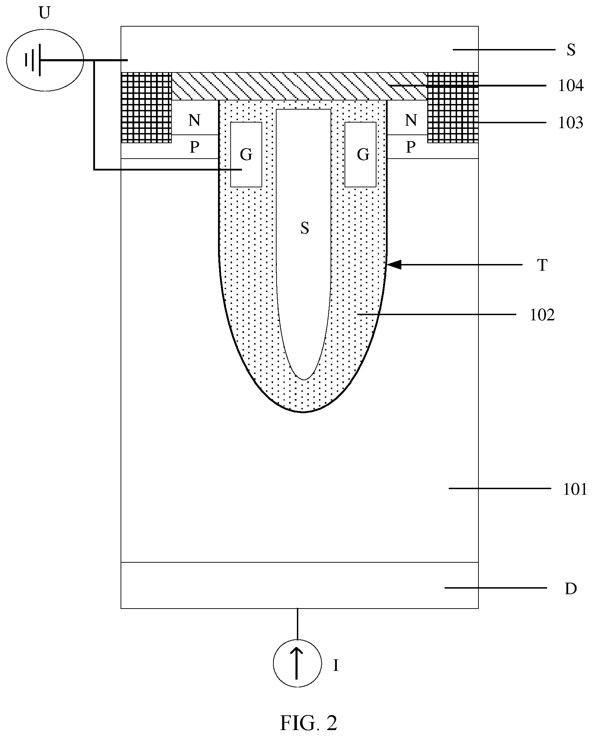

FIG. 2 is a schematic diagram of another structure of another field-effect transistor. As shown in FIG. 2, the field-effect transistor is a shield gate trench field-effect transistor. The field-effect transistor may include: a semiconductor substrate 101; a source S, a gate G, and an insulating oxide layer 102 that are located on one side of the semiconductor substrate 101; and a drain D located on the other side of the semiconductor substrate 101. In addition, the semiconductor substrate 101 further includes a trench T. In the trench T, the gate G, the source S, and the insulating oxide layer 102 are disposed. The insulating oxide layer 102 is configured to insulate the gate G and the source S in the trench T. Optionally, a material of the semiconductor substrate 101 may include silicon, and a material of the insulating oxide layer 102 may include silicon oxide. In FIG. 2, a shield gate trench field-effect transistor of a left-right structure is used as an example for illustration. The shield gate trench field-effect transistor may alternatively be of a vertical structure. This is not limited herein.

Still with reference to FIG. 2, the field-effect transistor may further include a contact hole 103 and a dielectric layer 104. The semiconductor substrate 101 has a P region and an N region near the trench T. The contact hole 103 is filled with a metal material. The contact hole 103 is connected to the source S and the P region in the semiconductor substrate 101. The dielectric layer 104 is configured to insulate the gate G and the source S. The dielectric layer 104 has a flattening effect. The source S in the field-effect transistor is divided into two parts, with one part of the source S located on the dielectric layer 104 and the other part of the source S located in the trench T. In addition, the part of the source S located on the dielectric layer 104 and the part of the source S located in the trench T are connected to each other. Likewise, the gate G in the field-effect transistor is also divided into two parts, with the two parts of the gate G located on two sides of the source S in the trench T, respectively. In addition, the two parts of the gate G are connected to each other.

In the field-effect transistor shown in FIG. 2, the gate G and the source S are located on one side of the semiconductor substrate 101, and the drain D is located on the other side of the semiconductor substrate 101. In this way, when the field-effect transistor is conducted, a current flows from the drain D to the source S. To be specific, the current flows vertically in the semiconductor substrate 101, fully utilizing an area of the semiconductor substrate 101. In addition, with the trench T provided in the semiconductor substrate 101, a direction of an electric field may change, increasing a withstanding voltage across the source S and the drain D in the field-effect transistor.

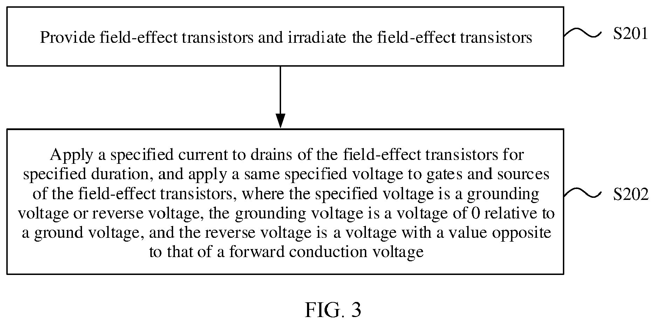

FIG. 3 is a flowchart of a field-effect transistor production method according to an embodiment of this application relating to the present invention. The production method may be used to produce any field-effect transistor, for example, field-effect transistors of the two structures shown in FIG. 1 and FIG. 2. Certainly, the production method may also be used to produce field-effect transistors of other structures. This is not limited herein in this application. In this application, producing the field-effect transistor shown in FIG. 2 is used as an example herein for description. As shown in FIG. 3, the field-effect transistor production method according to this embodiment of this application may include the following steps.

S201: Provide field-effect transistors and irradiate the field-effect transistors, with the structure shown in FIG. 2 as an example.

S202: Apply a specified current I to drains D of the field-effect transistors for specified duration, and apply a same specified voltage U to gates G and sources S of the field-effect transistors, where the specified voltage U is a grounding voltage or reverse voltage, the grounding voltage is a voltage of 0V relative to a ground voltage, and the reverse voltage is a voltage opposite to a forward conduction voltage in positive and negative senses of values. For example, if the forward conduction voltage is a positive voltage, the reverse conduction voltage is a negative voltage.

In this embodiment of this application, the field-effect transistors are irradiated, reducing minority carrier lifetimes of the field-effect transistors, and further improving reverse recovery performance of parasitic diodes in the field-effect transistors. However, during the irradiation, the field-effect transistors are bombarded by high-energy particles, forming unstable trapped charges at an insulating oxide layer and at an interface between the insulating oxide layer and a semiconductor substrate. These trapped charges are difficult to remove. As a result, for the plurality of field-effect transistors on the same semiconductor substrate (for example, a wafer), some field-effect transistors have many unstable trapped charges, some field-effect transistors have few unstable trapped charges, and some field-effect transistors even do not have trapped charges, resulting in low uniformity in performance of the plurality of field-effect transistors on the same semiconductor substrate. In this embodiment of this application, the specified current is applied to the drains of the field-effect transistors for the specified duration, and the same specified voltage is applied to the gates and sources, enabling the field-effect transistors to be in a reverse biased state in a case of cut-off. The reverse biased state may be a state opposite to a forward conducting state. For example, a field-effect transistor is an N-type transistor. When a positive voltage is applied to a gate, the field-effect transistor is forward conducted. When a negative voltage is applied to the gate, the field-effect transistor is in a reverse biased state. In addition, a specific quantity of electron-hole pairs may be generated at the insulating oxide layer and at the interface between the insulating oxide layer and the semiconductor substrate. These electron-hole pairs may recombine with the trapped charges, removing the unstable trapped charges generated during the irradiation. In this way, the trapped charges in the plurality of field-effect transistors on the same semiconductor substrate are all in a stable state, and differences between performance of the different field-effect transistors on the same semiconductor substrate are slight, increasing uniformity in performance of the plurality of field-effect transistors on the same semiconductor substrate. In other words, leakage currents at the drains can be reduced, uniformity of leakage currents can be increased, convergence of a drain-source withstanding voltage can be improved, and further, the field-effect transistors can be used in a wider range of fields. Experiments verify that the production method in this embodiment of this application can help improve leakage current performance and voltage withstanding performance of the field-effect transistors by more than 10%. In addition, the same specified voltage is applied to the gates and sources of the field-effect transistors, keeping the gates and sources at a same potential, to prevent the field-effect transistors from being broken down in the reverse biased state.

It should be noted that in this embodiment of this application, the production method is described using the field-effect transistor shown in FIG. 2 as an example. During specific implementation, the production method in this embodiment of this application may also be used to produce other field-effect transistors, for example, the field-effect transistor shown in FIG. 1. Examples are not described herein one by one.

Still with reference to FIG. 2, in this embodiment of this application, the specified current I is in a range of 0.1 µA to 100 mA in step S202. To be specific, a current in the range of 0.1 µA to 100 mA may be applied to the drains D of the field-effect transistors. During actual application, if the specified current I applied to the drains D of the field-effect transistors is greater than 100 mA, that is, if the current applied to the drains D is excessively large, the field-effect transistors are prone to burnout. If the specified current I applied to the drains D of the field-effect transistors is less than 0.1 µA, that is, if the current applied to the drains D is excessively small, an effect on the field-effect transistors is small, enough electron-hole pairs cannot be generated, and the specified current I needs to be applied to the drains D for long duration. Therefore, in this embodiment of this application, the specified current I in the range of 0.1 µA to 100 mA is applied to the drains D of the field-effect transistors, preventing the field-effect transistors from being burnt out on a basis of ensuring that enough electron-hole pairs are generated.

Optionally, the specified duration is in a range of 1 µs to 100s in step S202. For example, the specified current may be continuously applied to the drains of the field-effect transistors for the specified duration. During actual application, if the specified current I is applied to the drains D of the field-effect transistors for duration greater than 100s, that is, if the current is applied to the drains D for excessively long duration, the field-effect transistors likely have an excessively large amount of heat, resulting in damage to the field-effect transistors. In addition, if the current is applied to the drains D for longer duration, operating costs are higher. If the specified current I is applied to the drains D of the field-effect transistors for duration less than 1 µs, that is, if the current is applied to the drains D for excessively short duration, an effect on the field-effect transistors is small, and enough electron-hole pairs cannot be generated. Therefore, in this embodiment of this application, duration for which the specified current I is applied to the drains D is controlled to be in the range of 1 µs to 100s, preventing the field-effect transistors from being damaged on a basis of ensuring that enough electron-hole pairs are generated. During specific implementation, the specified duration for which the current is applied to the drains D may be determined based on a magnitude of the specified current I applied to the drains D. For example, if the specified current I applied to the drains D is large, the duration for which the specified current I is applied to the drains D may be shortened, and may be set based on an actual requirement. The magnitude of the specified current I and the specified duration are not limited herein.

In some embodiments of this application relating to the present invention, in step S202, the same specified voltage is applied to the gates and sources simultaneously when the current is applied to the drains of the field-effect transistors, to keep the field-effect transistors in the reverse biased state. In addition, the gates and sources are kept at a same potential, preventing the field-effect transistors from being broken down in the reverse biased state. Optionally, the specified voltage may be the grounding voltage. To be specific, the gates and sources are both grounded. Alternatively, the specified voltage may be the reverse voltage. When the field-effect transistors are P-type transistors, the reverse voltage is a positive voltage; and when the field-effect transistors are N-type transistors, the reverse voltage is a negative voltage. In this way, the field-effect transistors can be kept in the reverse biased state.

The field-effect transistor shown in FIG. 2 is used as an example. As shown in FIG. 2, step S201 may include the following processes.

Processing front sides of the field-effect transistors: Form the gates G and sources S of the plurality of field-effect transistors on a surface of one side of the semiconductor substrate 101. Optionally, the semiconductor substrate 101 may be patterned, to form the trench T on the surface of the semiconductor substrate 101. Then, the gate G and one part of the source S are formed in the trench T, and the gate G and the source S are insulated by the insulating oxide layer 102. Then, the dielectric layer 104 is formed above the trench T, and the other part of the source S is formed on the dielectric layer 104.

Irradiation: Irradiate the semiconductor substrate 101 on which the gates G and sources S are formed.

Processing back sides of the field-effect transistors: Form the drains D of the plurality of field-effect transistors on a surface of the other side of the semiconductor substrate 101, to obtain the plurality of field-effect transistors. The surface of the side that is of the semiconductor substrate 101 and that faces away from the sources S may be thinned and metalized, to form the drains D on the surface on the other side of the semiconductor substrate 101.

In this embodiment of this application, to improve production efficiency, a plurality of field-effect transistors are formed on a same semiconductor substrate. After the front sides of the field-effect transistors are processed and before the back sides of the field-effect transistors are processed, the semiconductor substrate 101 on which the gates G and sources S are formed is irradiated, making an irradiation process fully compatible with a production process of the field-effect transistors. In addition, after the front sides of the field-effect transistors are processed, the semiconductor substrate 101 on which the gates G and sources S are formed may be directly placed in an irradiation device, with no need to turn over the semiconductor substrate 101 repeatedly. In this case, a processing procedure is simpler, facilitating mass production.

Certainly, alternatively in step S201, the field-effect transistors may be irradiated after the back sides of the field-effect transistors are processed. To be specific, step S201 may include the following processes.

Processing front sides of the field-effect transistors: Form the gates G and sources S of the plurality of field-effect transistors on a surface of one side of the semiconductor substrate 101.

Processing back sides of the field-effect transistors: Form the drains D of the plurality of field-effect transistors on a surface of the other side of the semiconductor substrate 101, to obtain the field-effect transistors.

Irradiation: Irradiate the obtained field-effect transistors.

In this embodiment of this application, the field-effect transistors are irradiated after the front sides and back sides of the field-effect transistors are processed, also making an irradiation process compatible with a production process of the field-effect transistors.

It should be noted that in this embodiment of this application, the production method is described using the field-effect transistor shown in FIG. 2 as an example. During specific implementation, the field-effect transistor may also be of another structure. For example, the field-effect transistor may also be of the structure shown in FIG. 1. During actual processing, a procedure for processing a field-effect transistor may also be specified based on a specific structure of the field-effect transistor. This is not limited herein.

Optionally, in the production method provided in this embodiment of this application, the irradiating the field-effect transistors in step S201 may be as follows in an actual operation process: placing the field-effect transistors in an irradiation device to let high-energy particles bombard the field-effect transistors to complete irradiation. The irradiation includes electron irradiation, proton irradiation, or neutron irradiation. During specific implementation, a type of irradiation may be determined based on an actual requirement.

After step S201, the production method may further include: annealing the field-effect transistors.

During the irradiation, the field-effect transistors are bombarded by high-energy particles, forming trapped charges at the insulating oxide layer and at the interface between the insulating oxide layer and the semiconductor substrate. With the annealing operation performed, some trapped charges can be removed, improving the leakage current performance and the voltage withstanding performance of the field-effect transistors. However, generally, not all trapped charges can be removed by performing the annealing operation. In this embodiment of this application, after the irradiation, the specified current is applied to the drains of the field-effect transistors, and the same specified voltage is applied to the gates and sources. In this way, the field-effect transistors are in the reverse biased state in a case of cut-off, and a specific quantity of electron-hole pairs are generated at the insulating oxide layer and at the interface between the insulating oxide layer and the semiconductor substrate. These electron-hole pairs may recombine with the trapped charges. Therefore, the trapped charges generated during the irradiation are further removed, and the leakage current performance and the voltage withstanding performance of the field-effect transistors are further improved.

In some embodiments of this application relating to the present invention, the production method may further include the following steps.

In a first test phase, detect static parameters of the plurality of irradiated field-effect transistors that share the same semiconductor substrate, and compare the static parameters with preset standard parameters, to obtain a plurality of tested field-effect transistors. For example, the static parameters may be parameters such as a threshold voltage, a leakage current at a drain, uniformity of leakage currents, and a drain-source withstanding voltage, and certainly, may also be other parameters. This is not limited herein. Each static parameter may correspond to a preset standard parameter. For example, a preset standard parameter corresponding to uniformity of leakage currents may be 90%. During testing, if a detected static parameter reaches a corresponding standard parameter (for example, uniformity of leakage currents reaches 90%), the field-effect transistor passes the test; or if a detected static parameter does not reach a corresponding standard parameter (for example, uniformity of leakage currents does not reach 90%), the field-effect transistor fails the test. The field-effect transistor may be improved in a subsequent step, or a field-effect transistor with an excessively large difference between a static parameter and a preset standard parameter may be discarded.

Separate the plurality of field-effect transistors that are obtained after the first test phase ends, to obtain a plurality of field-effect transistors.

In a second test phase that follows the first test phase, detect static parameters of the obtained field-effect transistors, and compare the static parameters with preset standard parameters, to obtain tested field-effect transistors. The static parameters in the second test phase may also be parameters such as a threshold voltage, a leakage current at a drain, uniformity of leakage currents, and a drain-source withstanding voltage, and certainly, may also be other parameters. This is not limited herein. Similar to the first test phase, each static parameter may also correspond to a preset standard parameter in the second test phase. A preset standard parameter in the second test phase may be the same as or different from the preset standard parameter in the first test phase. For example, a preset standard parameter corresponding to uniformity of leakage currents may be 95%. During testing, if a detected static parameter reaches a corresponding standard parameter (for example, uniformity of leakage currents reaches 95%), the field-effect transistor passes the test; or if a detected static parameter does not reach a corresponding standard parameter (for example, uniformity of leakage currents does not reach 95%), the field-effect transistor fails the test. The field-effect transistor may be improved in a subsequent step, or a field-effect transistor with an excessively large difference between a static parameter and a preset standard parameter may be discarded.

In the first test phase and/or the second test phase, perform step S202.

During actual processing, to improve production efficiency, a plurality of field-effect transistors may be produced on a same semiconductor substrate. After a procedure for producing field-effect transistors completes, the semiconductor substrate may be divided, to obtain a plurality of field-effect transistors. After the procedure for producing field-effect transistors completes, the field-effect transistors may be tested in the first test phase, to detect static parameters of the field-effect transistors. In addition, after the semiconductor substrate is divided, field-effect transistors may be packaged, and the packaged field-effect transistors may be tested in the second test phase, to detect static parameters of the packaged field-effect transistors.

During testing of the field-effect transistors in the first test phase or the second test phase, test signals need to be applied to the sources, drains, or gates of the field-effect transistors by a test device. Therefore, in this embodiment of this application, step S202 is performed in the first test phase and/or the second test phase. For example, after they are applied to the field-effect transistors, a connection between parameters of the test device and the field-effect transistors may be simply adjusted, for applying of the specified current to the drains of the field-effect transistors and applying of the specified voltage to the gates and sources of the field-effect transistors. In this way, step S202 may be made compatible with a test process, with no need to add a new process, facilitating mass production and saving production costs. Certainly, during actual application, step S202 may be alternatively performed in another phase. For example, step S202 may be alternatively performed during testing that is performed before the field-effect transistors are put into service. This is not limited herein.

Based on a same technical concept, an embodiment of this application not according to the invention and present for illustration purposes further provides a field-effect transistor, which may be used in an integrated circuit. The field-effect transistor may perform functions such as switching, amplification, and providing variable resistance. The field-effect transistor is produced using any one of the foregoing production methods. In the foregoing production method, a current in a specific range of values is applied to drains of field-effect transistors for specified duration, and a same specified voltage is applied to gates and sources. In this way, the field-effect transistors can be in a reverse biased state in a case of cut-off, and a specific quantity of electron-hole pairs can be generated at an insulating oxide layer and at an interface between the insulating oxide layer and a semiconductor substrate. These electron-hole pairs may recombine with trapped charges, removing the trapped charges generated during irradiation. Therefore, for the field-effect transistor obtained using the foregoing production method, a leakage current at a drain is low, uniformity of leakage currents is high, and convergence of a drain-source withstanding voltage is good.

Based on a same technical concept, an embodiment of this application not according to the invention and present for illustration purposes further provides a circuit board. The circuit board includes any one of the foregoing field-effect transistors. The circuit board may be a printed circuit board (PCB) or another type of circuit board. This is not limited herein.

Based on a same technical concept, an embodiment of this application not according to the invention and present for illustration purposes further provides a switching circuit. The switching circuit may be a switching circuit in an AC-DC converter circuit, a high-voltage converter circuit, or a half-bridge rectifier circuit. The switching circuit includes a main board and any one of the foregoing field-effect transistors provided in embodiments of this application. The field-effect transistor is disposed on the main board. In this embodiment of this application, when any one of the foregoing production methods is used, trapped charges generated during irradiation can be removed, and an obtained field-effect transistor performs well. For example, a drain-source withstanding voltage of the field-effect transistor is high. Further, a switching circuit including the field-effect transistor also performs well. The switching circuit resolves a problem in a similar way to the foregoing field-effect transistor. Therefore, for implementation of the switching circuit, refer to implementation of the foregoing field-effect transistor. Repeated details are not described.

Although embodiments of this application have been described, persons skilled in the art can make additional changes and modifications to these embodiments once they learn of the basic creative concept. Therefore, the following claims are intended to be construed as to cover the embodiments and all changes and modifications falling within the scope of these claims.

## Claims

1. A field-effect transistor production method, comprising:
providing (S201) field-effect transistors and irradiating the field-effect transistors, wherein the irradiation includes electron irradiation, proton irradiation, or neutron irradiation; and
applying (S202) a specified current to drains of the field-effect transistors for specified duration, while applying a same specified voltage to gates and sources of the field-effect transistors,
wherein the specified voltage is a grounding voltage or reverse voltage, the grounding voltage is a voltage of 0V relative to a ground voltage, and the reverse voltage is a voltage with a value opposite to that of a forward conduction voltage;
wherein each field-effect transistor is a metal-oxide-semiconductor field-effect transistor;
wherein the providing field-effect transistors and irradiating the field-effect transistors comprises in the temporal order given below: forming the gates and sources of the plurality of field-effect transistors on a surface of one side of a semiconductor substrate;
irradiating the semiconductor substrate on the surface on which the gates and sources are formed; and
forming the drains of the plurality of field-effect transistors on a surface of the other side of the semiconductor substrate, to obtain the plurality of field-effect transistors; or
wherein the providing field-effect transistors and irradiating the field-effect transistors comprises in the temporal order given below: forming the gates and sources of the plurality of field-effect transistors on a surface of one side of a semiconductor substrate;
forming the drains of the plurality of field-effect transistors on a surface of the other side of the semiconductor substrate, to obtain the field-effect transistors; and
irradiating the semiconductor substrate on the surface on which the gates and source are formed.

2. The production method according to claim 1, wherein the specified current is in a range of 0.1 µA to 100 mA.

3. The production method according to claim 1, wherein the specified duration is in a range of 1 µs to 100s.

4. The production method according to claim 1, wherein when the field-effect transistors are P-type transistors, the reverse voltage is a positive voltage.

5. The production method according to claim 1, wherein when the field-effect transistors are N-type transistors, the reverse voltage is a negative voltage.

6. The production method according to any one of the claims 1 to 5, further comprising:
in a first test phase, detecting static parameters of the plurality of irradiated field-effect transistors that share the same semiconductor substrate, and comparing the static parameters with preset standard parameters, to obtain a plurality of tested field-effect transistors; then
dividing the semiconductor substrate to obtain a plurality of divided field-effect transistors; then packaging at least some of the divided field-effect transistors;
in a second test phase that follows the first test phase, detecting static parameters of the plurality of packaged field-effect transistors, and comparing the static parameters with preset standard parameters, to obtain a plurality of tested packaged field-effect transistors; and
the applying a specified current to drains of the field-effect transistors for specified duration comprises:
in the first test phase and/or the second test phase, applying the specified current to the drains of the field-effect transistors for the specified duration.

7. The production method according to any one of claims 1 to 6, wherein after the irradiating the field-effect transistors, the production method further comprises:
annealing the field-effect transistors.

## Patentansprüche

1. Herstellungsverfahren für Feldeffekttransistoren, das umfasst:
Bereitstellen (S201) von Feldeffekttransistoren und Bestrahlen der Feldeffekttransistoren, wobei es sich bei der Bestrahlung um Elektronenbestrahlung, Protonenbestrahlung oder Neutronenbestrahlung handeln kann; und
Anlegen (S202) eines spezifizierten Stroms an die Drains der Feldeffekttransistoren über eine spezifizierte Dauer, während gleichzeitig eine gleiche spezifizierte Spannung an die Gates und Sources der Feldeffekttransistoren angelegt wird,
wobei die spezifizierte Spannung eine Erdungsspannung oder eine Sperrspannung ist, die Erdungsspannung eine Spannung von 0 V bezüglich der Erdspannung ist und die Sperrspannung eine Spannung mit einem Wert ist, der dem einer Durchlassspannung entgegengesetzt ist;
wobei jeder Feldeffekttransistor ein Metall-Oxid-Halbleiter-Feldeffekttransistor ist;
wobei das Bereitstellen von Feldeffekttransistoren und das Bestrahlen der Feldeffekttransistoren in der nachstehend angegebenen zeitlichen Reihenfolge umfasst:
Bilden der Gates und Sources der Vielzahl von Feldeffekttransistoren auf einer Oberfläche auf einer Seite eines Halbleitersubstrats;
Bestrahlen des Halbleitersubstrats auf der Oberfläche, auf der die Gates und Sources gebildet sind; und
Bilden der Drains der Vielzahl von Feldeffekttransistoren auf einer Oberfläche der anderen Seite des Halbleitersubstrats, um so die Vielzahl von Feldeffekttransistoren zu erhalten; oder
wobei das Bereitstellen von Feldeffekttransistoren und das Bestrahlen der Feldeffekttransistoren in der nachstehend angegebenen zeitlichen Reihenfolge umfasst:
Bilden der Gates und Sources der Vielzahl von Feldeffekttransistoren auf einer Oberfläche auf einer Seite eines Halbleitersubstrats;
Bilden der Drains der Vielzahl von Feldeffekttransistoren auf einer Oberfläche der anderen Seite des Halbleitersubstrats, um so die Feldeffekttransistoren zu erhalten; und
Bestrahlen des Halbleitersubstrats auf der Oberfläche, auf der die Gates und Source gebildet sind.

2. Herstellungsverfahren nach Anspruch 1, wobei der spezifizierte Strom in einem Bereich von 0,1 µA bis 100 mA liegt.

3. Herstellungsverfahren nach Anspruch 1, wobei die spezifizierte Dauer in einem Bereich von 1 µs bis 100 s liegt.

4. Herstellungsverfahren nach Anspruch 1, wobei, wenn die Feldeffekttransistoren p-leitende Transistoren sind, die Sperrspannung eine positive Spannung ist.

5. Herstellungsverfahren nach Anspruch 1, wobei, wenn die Feldeffekttransistoren n-leitende Transistoren sind, die Sperrspannung eine negative Spannung ist.

6. Herstellungsverfahren nach einem der Ansprüche 1 bis 5, das ferner umfasst:
in einer ersten Testphase, Erkennen von statischen Parametern der Vielzahl von bestrahlten Feldeffekttransistoren, die dasselbe Halbleitersubstrat nutzen, und
Vergleichen der statischen Parameter mit voreingestellten Standardparametern, um so eine Vielzahl von getesteten Feldeffekttransistoren zu erhalten; sodann Teilen des Halbleitersubstrats, um so eine Vielzahl von geteilten Feldeffekttransistoren zu erhalten; sodann Verpacken mindestens einiger der geteilten Feldeffekttransistoren;
in einer zweiten Testphase, die auf die erste Testphase folgt, Erkennen von statischen Parametern der Vielzahl von verpackten Feldeffekttransistoren und Vergleichen der statischen Parameter mit voreingestellten Standardparametern, um so eine Vielzahl von getesteten verpackten Feldeffekttransistoren zu erhalten; und
wobei das Anlegen eines spezifizierten Stroms an die Drains der Feldeffekttransistoren über eine spezifizierte Dauer umfasst:
in der ersten Testphase und/oder der zweiten Testphase, Anlegen des spezifizierten Stroms an die Drains der Feldeffekttransistoren über die spezifizierte Dauer.

7. Herstellungsverfahren nach einem der Ansprüche 1 bis 6, wobei das Herstellungsverfahren nach dem Bestrahlen der Feldeffekttransistoren ferner umfasst:
Tempern der Feldeffekttransistoren.

## Revendications

1. Procédé de production de transistor à effet de champ, comprenant :
la fourniture (S201) de transistors à effet de champ et l'irradiation des transistors à effet de champ, dans lequel l'irradiation comporte une irradiation par électrons, une irradiation par protons, ou une irradiation par neutrons ; et
l'application (S202) d'un courant spécifié à des drains des transistors à effet de champ pendant une durée spécifiée, tout en appliquant une même tension spécifiée à des portes et sources des transistors à effet de champ,
dans lequel la tension spécifiée est une tension de mise à la masse ou une tension inverse, la tension de mise à la masse est une tension de 0 V par rapport à une tension de masse, et la tension inverse est une tension avec une valeur opposée à celle d'une tension de conduction directe ;
dans lequel chaque transistor à effet de champ est un transistor à effet de champ métal-oxyde-semiconducteur ;
dans lequel la fourniture de transistors à effet de champ et l'irradiation des transistors à effet de champ comprennent, dans l'ordre temporel donné ci-dessous :
la formation des portes et sources de la pluralité de transistors à effet de champ sur une surface d'un côté d'un substrat semi-conducteur ;
l'irradiation du substrat semi-conducteur sur la surface sur laquelle sont formées les portes et sources ; et
la formation des drains de la pluralité de transistors à effet de champ sur une surface de l'autre côté du substrat semi-conducteur, afin d'obtenir la pluralité de transistors à effet de champ ; ou
dans lequel la fourniture de transistors à effet de champ et l'irradiation des transistors à effet de champ comprennent, dans l'ordre temporel donné ci-dessous :
la formation des portes et sources de la pluralité de transistors à effet de champ sur une surface d'un côté d'un substrat semi-conducteur ;
la formation des drains de la pluralité de transistors à effet de champ sur une surface de l'autre côté du substrat semi-conducteur, afin d'obtenir les transistors à effet de champ ; et
l'irradiation du substrat semi-conducteur sur la surface sur laquelle sont formées les portes et sources.

2. Procédé de production selon la revendication 1, dans lequel le courant spécifié est compris dans une plage de 0,1 µA à 100 mA.

3. Procédé de production selon la revendication 1, dans lequel la durée spécifiée est comprise dans une plage de 1 µs à 100 s.

4. Procédé de production selon la revendication 1, dans lequel, lorsque les transistors à effet de champ sont des transistors de type P, la tension inverse est une tension positive.

5. Procédé de production selon la revendication 1, dans lequel, lorsque les transistors à effet de champ sont des transistors de type N, la tension inverse est une tension négative.

6. Procédé de production selon l'une quelconque des revendications 1 à 5, comprenant en outre :
dans une première phase de test, la détection de paramètres statiques de la pluralité de transistors à effet de champ irradiés qui partagent le même substrat semi-conducteur, et la comparaison des paramètres statiques avec des paramètres standard prédéfinis, afin d'obtenir une pluralité de transistors à effet de champ testés ; puis
la division du substrat semi-conducteur afin d'obtenir une pluralité de transistors à effet de champ divisés ; puis l'encapsulation d'au moins une partie des transistors à effet de champ divisés ;
dans une seconde phase de test qui suit la première phase de test, la détection de paramètres statiques de la pluralité de transistors à effet de champ encapsulés, et la comparaison des paramètres statiques à des paramètres standard prédéfinis, afin d'obtenir une pluralité de transistors à effet de champ encapsulés testés ; et
l'application d'un courant spécifié à des drains des transistors à effet de champ pendant une durée spécifiée comprend :
dans la première phase de test et/ou la seconde phase de test, l'application du courant spécifié aux drains des transistors à effet de champ pendant la durée spécifiée.

7. Procédé de production selon l'une quelconque des revendications 1 à 6, dans lequel, après l'irradiation des transistors à effet de champ, le procédé de production comprend en outre :
le recuit des transistors à effet de champ.
